# EUROPEAN PATENT APPLICATION

(11) **EP 4 776 828 A2**
(43) Date of publication of application: **15.07.2026**
(21) Application number: 25225263.0
(22) Date of filing: 18.12.2025
(51) Int. Cl.: H10P 72/00, H10P 72/76

(54) **SYSTEM FOR INSPECTING WAFER**

(30) Priority: 20.12.2024 US 202463737348 P
(71) Applicant: Scientech Corporation, Tapei City 11491 (TW)
(72) Inventor: TSAI, Yung-Lin, Neihu Dist., Taipei City 11491 (TW); TSAI, Wen-Ping, Neihu Dist., Taipei City 11491 (TW)
(74) Representative: Stöckeler, Ferdinand

(57) **Abstract**

A system (1) for inspecting a wafer (90) having a coating layer is provided. The system (1) includes a main body (11), an optical sensor module (13) and a processing module (14). The main body (11) defines an inspection space (110) where the wafer (90) is to be disposed. The optical sensor module (13) is mounted on the main body (11) and is configured to inspect the wafer (90) so as to obtain a sensing dataset of the wafer (90). The processing module (14) is electrically connected to the optical sensor module (13) and is configured to determine a quality of the coating layer of the wafer (90) based on the sensing dataset.

## Description

The disclosure relates to a system for performing quality control, and more particularly to a system for inspecting a wafer that has a coating layer.

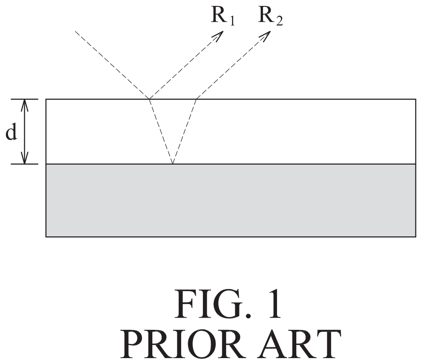

A conventional system for measuring a thickness (d) of a coating layer (B) of a wafer often uses optical techniques that analyze light reflected from a surface of the wafer (as shown in Figure 1). Specifically, when an incident light (L) strikes on the surface of the wafer at an angle, a first reflected light (R₁) of the incident light (L) being reflected by a surface of the coating layer (B) and a second reflected light (R₂) of the incident light (L) being reflected by an interface between the coating layer (B) and the substrate (C) may be obtained. The thickness (d) of the coating layer (B) of the wafer may then be obtained based on the first reflected light (R₁) and the second reflected light (R₂).

However, optical signals obtained using the conventional system are easily affected by vibration of the wafer during inline processing, resulting in signal offset and reduced accuracy of the measurement. To reduce vibration of the wafer, additional vibration-reduction equipment (e.g., an active vibration isolation system) is typically required, and is often installed off-line, which requires the wafer to be temporarily removed from the inline processing to the vibration-reduction equipment, thereby interrupting the production flow. Moreover, the conventional system generally requires waiting for a certain period for the optical signal to stabilize so that a reliable reading may be obtained, which may be time consuming.

Therefore, an object of the disclosure is to provide a system for inspecting a wafer that can alleviate at least one of the drawbacks of the prior art.

According to an aspect of the disclosure, there is provided a system for inspecting a wafer that has a coating layer according to claim 1.

Other features and advantages of the disclosure will become apparent in the following detailed description of the embodiment(s) with reference to the accompanying drawings. It is noted that various features may not be drawn to scale.
Figure 1 is a schematic view illustrating a conventional optical technique for measuring a thickness of a coating layer of a wafer.
Figure 2 is a block diagram illustrating a system for inspecting a wafer that has a coating layer according to an embodiment of the disclosure.
Figure 3 is a schematic top view illustrating the system according to an embodiment of the disclosure.
Figure 4 is another schematic side view illustrating the system according to an embodiment of the disclosure.
Figure 5 is a flow chart illustrating a uniform determination procedure according to an embodiment of the disclosure.
Figure 6 is a flow chart illustrating a defect determination procedure according to an embodiment of the disclosure.
Figure 7 is a flow chart illustrating a thickness determination procedure according to an embodiment of the disclosure.
Figure 8 is a grayscale image containing a wafer captured by an optical sensor module of the system according to an embodiment of the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

It should be noted herein that for clarity of description, spatially relative terms such as "top," "bottom," "upper," "lower," "on," "above," "over," "downwardly," "upwardly" and the like may be used throughout the disclosure while making reference to the features as illustrated in the drawings. The features may be oriented differently (e.g., rotated 90 degrees or at other orientations) and the spatially relative terms used herein may be interpreted accordingly.

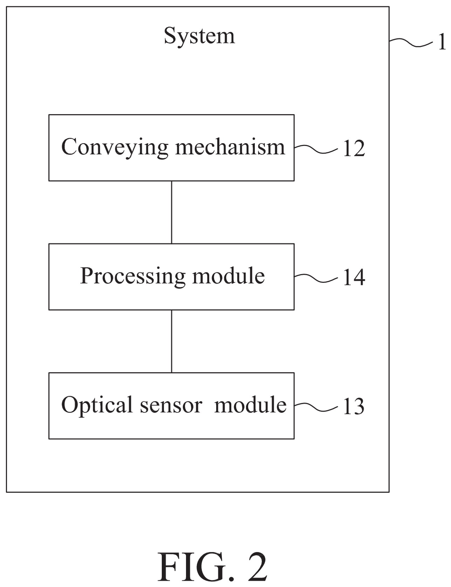

Referring to Figures 2 to 4, according to an embodiment of the disclosure, a system 1 for inspecting a wafer 90 that has a coating layer is provided. The system 1 includes a main body 11, a conveying mechanism 12, an optical sensor module 13, and a processing module 14 that is electrically connected to the conveying mechanism 12 and the optical sensor module 13. The main body 11 defines an inspection space 110 where the wafer 90 is to be disposed. The conveying mechanism 12 is mounted on the main body 11, and is configured to horizontally convey the wafer 90 through the system 1. In this embodiment, the system 1 is installed on a production line (not shown) of the wafer 90; that is to say, the system 1 is part of the production line. In this embodiment, the system 1 further includes a load port 70 that is mounted on the main body 11.

In this embodiment, the conveying mechanism 12 includes a robotic arm 121 for holding the wafer 90, a slide rail 123 horizontally extending in a first direction (D1), a slide block 124 slidably mounted on the slide rail 123, and a telescopic cylinder 122 connected between the robotic arm 121 and the slide block 124 and configured to extend and retract horizontally in a second direction (D2) that is perpendicular to the first direction (D1). By virtue of the above-mentioned structural configuration of the conveying mechanism 12, the wafer 90 held by the robotic arm 121 may be moved horizontally in the first direction (D1) by the slide block 124 sliding along the slide rail 123, and in the second direction (D2) by the telescopic cylinder 122 extending and retracting in the second direction (D2). However, the disclosure is not limited to such.

The optical sensor module 13 is mounted on the main body 11 and is configured to inspect the wafer 90 so as to obtain a sensing dataset of the wafer 90.

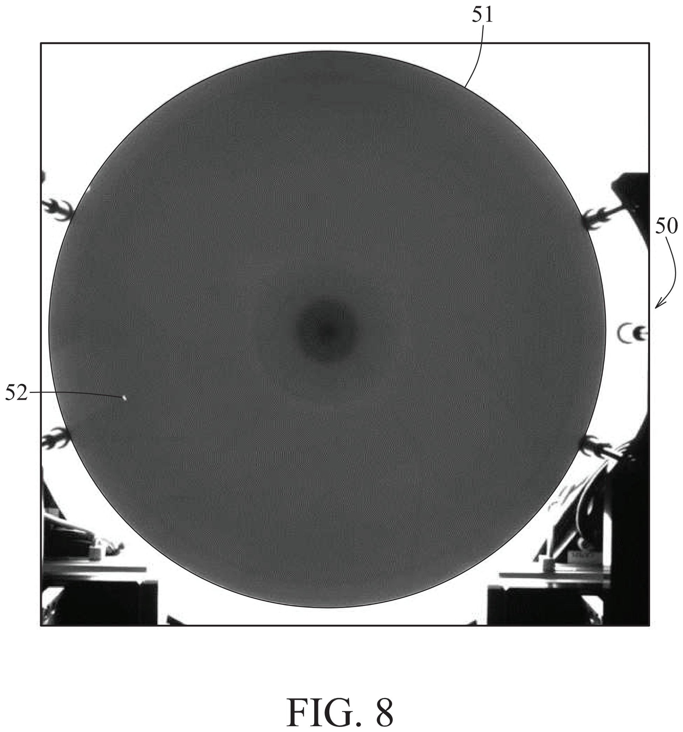

In some embodiments, the optical sensor module 13 includes a set of a backlight module 131 and a charge-coupled device (CCD) 132. The backlight module 131 is disposed on the main body 11 at a lower part of the inspection space 110 and is configured to emit light upwardly. The CCD 132 is disposed on the main body 11 at an upper part of the inspection space 110 over the backlight module 131 and is configured to obtain a grayscale image 50 containing the wafer 90 (see Figure 8) that is disposed in the inspection space 110 between the CCD 132 and the backlight module 131. In such a case, the sensing dataset obtained by the optical sensor module 13 at least includes the grayscale image 50. The conveying mechanism 12 is configured to be controlled by the processing module 14 to convey the wafer 90 to a position below the CCD 132, such that the CCD 132 is able to capture the grayscale image 50. In some embodiments, the backlight module 131 may be implemented using one or more light-emitting diodes (LEDs), or other suitable illumination devices.

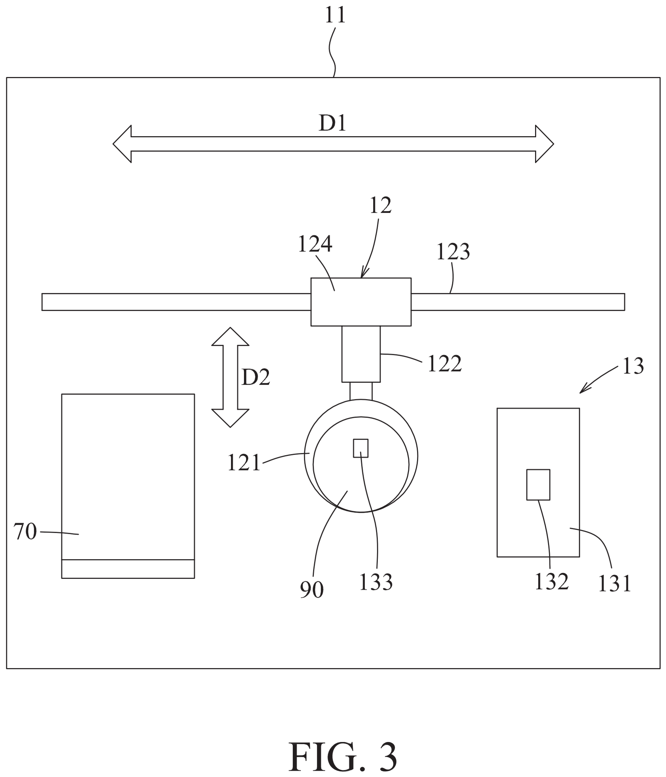

In some embodiments, the optical sensor module 13 includes a set of an optical transmitter 133 and an optical receiver 134, where one of the optical transmitter 133 and the optical receiver 134 is disposed at the upper part of the inspection space 110, and another one of the optical transmitter 133 and the optical receiver 134 is disposed at the lower part of the inspection space 110. (In Figure 3, the optical transmitter 133 is exemplified to be disposed at the upper part, and the optical receiver 134 is exemplified to be disposed at the lower part).

The optical transmitter 133 is configured to emit a light beam at a predetermined power toward the wafer 90 that is disposed in the inspection space 110 between the optical transmitter 133 and the optical receiver 134. The optical receiver 134 is configured to receive the light beam emitted by the optical transmitter 133, and to determine a received power of the light beam thus received. In such a case, the sensing dataset obtained by the optical sensor module 13 at least includes the received power. The conveying mechanism 12 is configured to be controlled by the processing module 14 to convey the wafer 90 to a position between the optical transmitter 133 and the optical receiver 134, such that the light beam emitted by the optical transmitter 133 penetrates the wafer 90 and is received by the optical receiver 134. In some embodiments, the set of the optical transmitter 133 and the optical receiver 134 is movably mounted on the main body 11, and the processing module 14 is configured to control the set of the optical transmitter 133 and the optical receiver 134 to move horizontally or to rotate (e.g., through another slide rail), such that the wafer 90 is at the position for the optical transmitter 133 to emit the light beam. In some embodiments, the optical transmitter 133 is an infrared (IR) emitter that is configured to emit an infrared light beam, and the optical receiver 134 is an IR receiver that is configured to receive the infrared light beam.

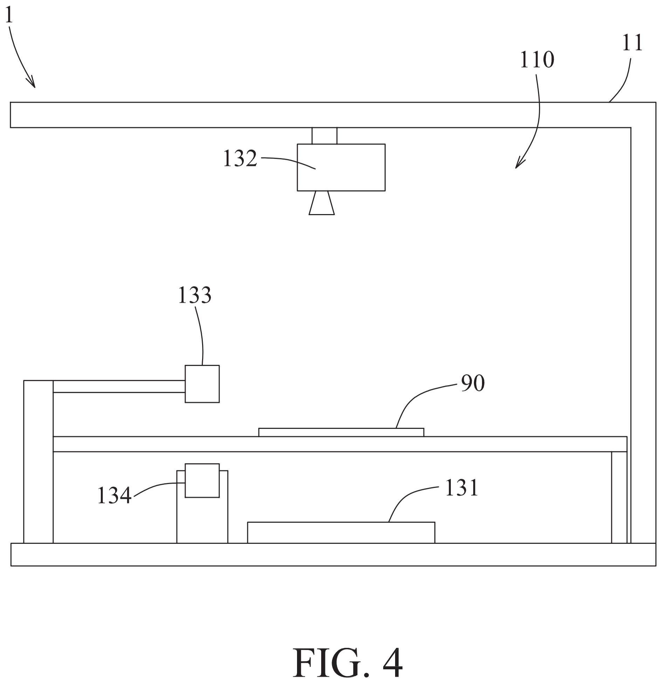

In some embodiments, as exemplified in Figures 3 and 4, the optical sensor module 13 may include both the set of the backlight module 131 and the CCD 132 and the set of the optical transmitter 133 and the optical receiver 134, and the sensing dataset obtained by the optical sensor module 13 includes both the grayscale image 50 and the received power. In one example, the set of the backlight module 131 and the CCD 132, the set of the optical transmitter 133 and the optical receiver 134, and the load port 70 may be aligned along a direction of the production line (e.g., along the first direction (D1)), but the disclosure is not limited to such.

The processing module 14 is configured to control the conveying mechanism 12 to convey the wafer 90, to control the optical sensor module 13 to obtain the sensing dataset, and to perform a quality determination process to determine whether a quality of the coating layer of the wafer 90 meets a predetermined standard based on the sensing dataset. In this embodiment, the processing module 14 may include, but is not limited to, one or more of a single core processor, a multi-core processor, a dual-core mobile processor, a microprocessor, a microcontroller, a digital signal processor (DSP), a field-programmable gate array (FPGA), an application specific integrated circuit (ASIC), a radio-frequency integrated circuit (RFIC), a system on a chip (SoC), etc.

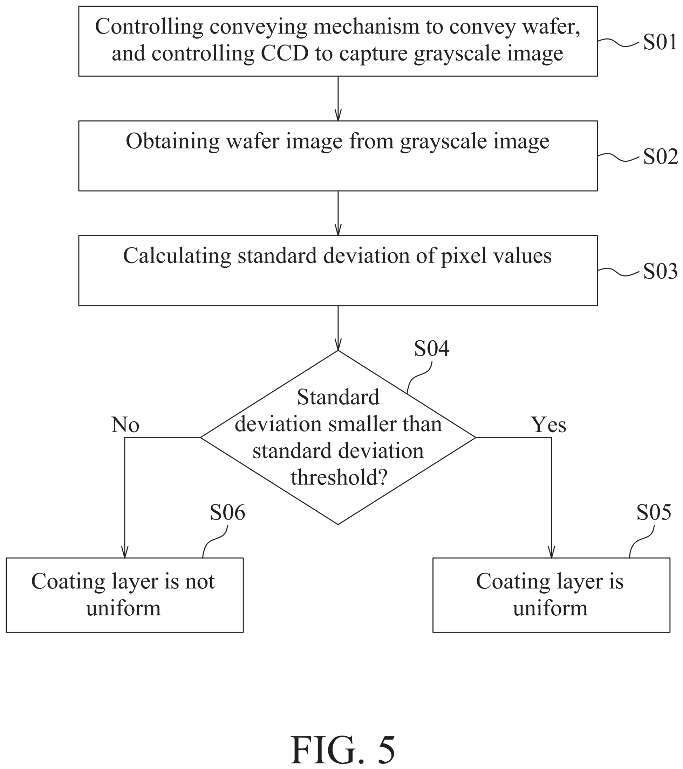

In some embodiments where the optical sensor module 13 at least includes the set of the backlight module 131 and the CCD 132, the quality determination process includes a uniform determination procedure to determine whether the coating layer of the wafer 90 is uniform based on the grayscale image 50. That is to say, the predetermined standard is that the coating layer of the wafer 90 is uniform. The uniform determination procedure includes steps S01 to S05, as shown in Figure 5.

In step S01, the processing module 14 controls the conveying mechanism 12 to convey the wafer 90 to a position below the CCD 132, and controls the CCD 132 to capture the grayscale image 50 containing the wafer 90. In some embodiments, the processing module 14 further controls the backlight module 131 to emit light while controlling the CCD 132 to capture the grayscale image 50; in some embodiments, the backlight module 131 is configured to emit light at all times.

In step S02, the processing module 14 receives the grayscale image 50 from the optical sensor module 13, and obtains a wafer image of the wafer 90 from the grayscale image 50, where the wafer image represents only the wafer 90 and includes a plurality of pixels each having a pixel value.

To describe in further detail, the processing module 14 obtains the wafer image by circling a circular portion 51 of the grayscale image 50 with a predetermined radius and a center at a predetermined position of the grayscale image 50, and uses the circular portion 51 as the wafer image. The predetermined radius is set to be equal to or slightly greater than a radius of the wafer 90 in the grayscale image 50, which depends on a production specification of the production line. The predetermined position is set based on a known position of the wafer 90 in the grayscale image 50 captured by the CCD 132 when the wafer 90 is conveyed to be below the CCD 132 by the conveying mechanism 12. As such, the circular portion 51 represents only the wafer 90.

In step S03, the processing module 14 calculates a standard deviation of the pixel values respectively of the pixels of the wafer image.

In step S04, the processing module 14 determines whether the standard deviation of the pixel values respectively of the pixels of the wafer image is smaller than a standard deviation threshold. In response to determining that the standard deviation is smaller than the standard deviation threshold, a flow of the uniform determination procedure proceeds to step S05; otherwise, in response to determining that the standard deviation is not smaller than the standard deviation threshold, the flow proceeds to step S06. It should be noted that the standard deviation threshold may be set according to user needs, and may be adjusted according to a recipe for processing a wafer manufactured by a production line where the system 1 is installed on.

In step S05, the processing module 14 determines that the coating layer of the wafer 90 is uniform and that the quality of the coating layer of the wafer 90 meets the predetermined standard, and controls the conveying mechanism 12 to convey the wafer 90 down the production line.

In step S06, the processing module 14 determines that the coating layer of the wafer 90 is not uniform and that the quality of the coating layer of the wafer 90 does not meet the predetermined standard, and controls the conveying mechanism 12 to convey the wafer 90 to the load port 70.

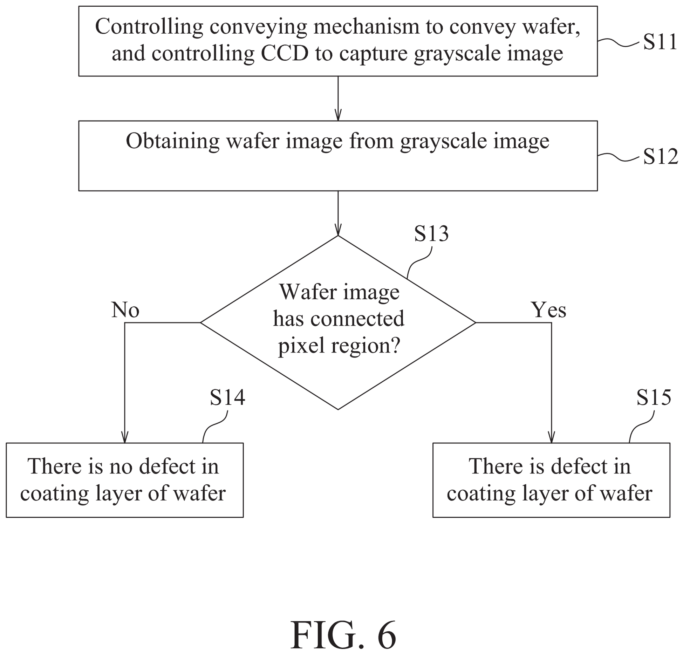

In some embodiments where the optical sensor module 13 at least includes the set of the backlight module 131 and the CCD 132, the quality determination process includes a defect determination procedure to determine whether a defect exists in the coating layer of the wafer 90 based on the grayscale image 50. That is to say, the predetermined standard is that the coating layer of the wafer 90 does not have a defect. The defect determination procedure includes steps S11 to S15, as shown in Figure 6.

In step S11, the processing module 14 controls the conveying mechanism 12 to convey the wafer 90 to the position below the CCD 132, and controls the CCD 132 to capture the grayscale image 50 containing the wafer 90.

In step S12, the processing module 14 receives the grayscale image 50 from the optical sensor module 13, and obtains the wafer image of the wafer 90 from the grayscale image 50 in a similar manner as in step S02.

In step S13, the processing module 14 determines whether the wafer image has a connected pixel region 52, where each pixel of the connected pixel region 52 has a pixel value greater than a predetermined white value (e.g., 150) and a pixel count of the connected pixel region 52 is greater than a predetermined count value (e.g., 20). In some embodiments, when the predetermined radius is set to be slightly greater than the radius of the wafer 90, the pixel count of the connected pixel region 52 may be limited to be smaller than another predetermined count value (e.g., 100,000), so as to exclude the white background that is not part of the wafer 90 in the wafer image. In response to determining that the wafer image has the connected pixel region 52, a flow of the defect determination procedure proceeds to step S14; otherwise, in response to determining that the wafer image does not have the connected pixel region 52, the flow proceeds to step S15.

In step S14, the processing module 14 determines that there is a defect in the coating layer of the wafer 90 and that the quality of the coating layer of the wafer 90 does not meet the predetermined standard, and controls the conveying mechanism 12 to convey the wafer 90 to the load port 70.

In step S15, the processing module 14 determines that there is no defect in the coating layer of the wafer 90 and that the quality of the coating layer of the wafer 90 meets the predetermined standard, and controls the conveying mechanism 12 to convey the wafer 90 down the production line.

In some embodiments where the optical sensor module 13 at least includes the set of the backlight module 131 and the CCD 132, the quality determination process includes both the uniform determination procedure and the defect determination procedure. It should be noted that the uniform determination procedure and the defect determination procedure may be performed one after another, or may be performed simultaneously. In such a case, if the uniform determination procedure is performed first, steps S11 and S12 may be omitted, and if the defect determination procedure is performed first, steps S01 and S02 may be omitted.

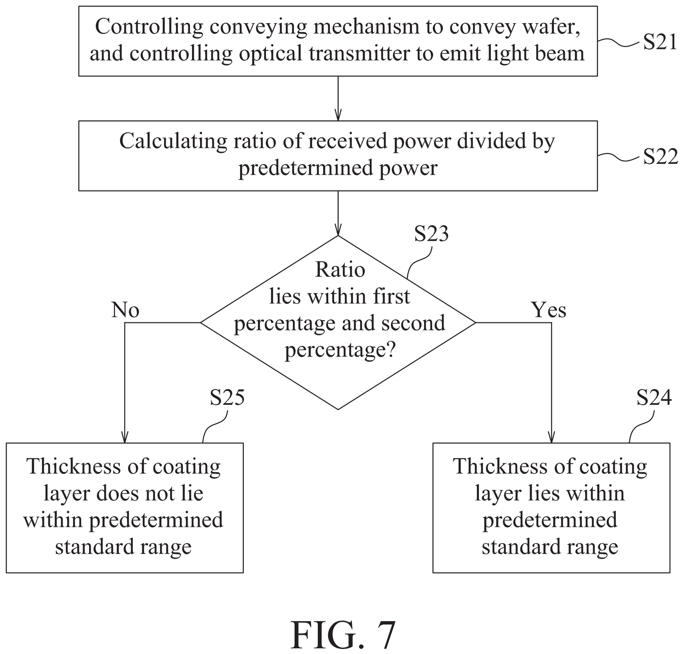

In some embodiments where the optical sensor module 13 at least includes the set of the optical transmitter 133 and the optical receiver 134, the processing module 14 is configured to pre-store the predetermined power of the light beam output by the optical transmitter 133, and the quality determination process includes a thickness determination procedure to determine whether a thickness of the coating layer of the wafer 90 lies within a predetermined standard range based on the received power and the predetermined power. That is to say, the predetermined standard is that the thickness of the coating layer of the wafer 90 lies within the predetermined standard range. The thickness determination procedure includes steps S21 to S25, as shown in Figure 7. It should be noted that, the processing module 14 is configured to further pre-store a first percentage and a second percentage corresponding respectively to an upper limit and a lower limit of the predetermined standard range. In one example, the first percentage is equal to 20% and the second percentage is equal to 16%, but the values may vary depending on a user requirement for the thickness of the coating layer of the wafer 90, and should not be limited to the above-mentioned example. The system 1 may obtain, when it is first installed on the production line, the first percentage and the second percentage in advance by inspecting wafers that are manufactured by the production line and that have been inspected and confirmed to have a coating layer with thicknesses that are equal to the upper limit of the predetermined standard range and the lower limit of the predetermined standard range.

In step S21, the processing module 14 controls the conveying mechanism 12 to convey the wafer 90 to a position between the optical transmitter 133 and the optical receiver 134, and controls the optical transmitter 133 to emit the light beam to the wafer 90, such that the light beam emitted by the optical transmitter 133 penetrates the wafer 90 and then is received by the optical receiver 134.

In step S22, the processing module 14 obtains the received power from the optical sensor module 13, and calculates a ratio of the received power to the predetermined power.

In step S23, the processing module 14 determines whether the ratio of the received power to the predetermined power is between the first percentage and the second percentage. In response to determining that the ratio is between the first percentage and the second percentage, a flow of the thickness determination procedure proceeds to step S24; otherwise, in response to determining that the ratio is not between the first percentage and the second percentage, the flow proceeds to step S25.

In step S24, the processing module 14 determines that the thickness of the coating layer of the wafer 90 lies within the predetermined standard range and that the quality of the coating layer of the wafer 90 meets the predetermined standard, and controls the conveying mechanism 12 to convey the wafer 90 down the production line.

In step S25, the processing module 14 determines that the thickness of the coating layer of the wafer 90 does not lie within the predetermined standard range and that the quality of the coating layer of the wafer 90 does not meet the predetermined standard, and controls the conveying mechanism 12 to convey the wafer 90 to the load port 70.

In some embodiments, in step S21, the processing module 14 is configured to control the conveying mechanism 12 to horizontally move the wafer 90 to pass between the optical transmitter 133 and the optical receiver 134, and to control the optical transmitter 133 to emit the light beam to the wafer 90 for multiple times, such that the light beam emitted by the optical transmitter 133 penetrates a plurality of sensing spots that are scattered on the coating layer of the wafer 90. In such a case, the optical receiver 134 obtains a plurality of received powers of the light beam that correspond respectively to the sensing spots, and in step S22, the processing module 14 calculates an average value of the received powers obtained by the optical receiver 134, and then calculates a ratio of the average value to the predetermined power. Then, in step S23, the processing module 14 determines whether the ratio of the average value to the predetermined power is between the first percentage and the second percentage.

In some embodiments where the optical sensor module 13 includes both the set of the backlight module 131 and the CCD 132 and the set of the optical transmitter 133 and the optical receiver 134, the quality determination process may include the uniform determination procedure, the defect determination procedure and the thickness determination procedure, and the wafer 90 is determined to not meet the predetermined standard when any one of the determination of whether the coating layer of the wafer 90 is uniform, the determination of whether there is no defect in the coating layer of the wafer 90, and the determination of whether the thickness of the coating layer of the wafer 90 lies within the predetermined standard range is negative.

In summary, according to the disclosure, the system 1 is configured to obtain the sensing dataset related to the wafer 90 for determining whether the wafer 90 meets the predetermined standard (e.g., the coating layer of the wafer 90 is uniform, there is no defect in the coating layer of the wafer 90, and/or the thickness of the coating layer of the wafer 90 lies within the predetermined standard range). When the wafer 90 is determined to have met the predetermined standard, the system 1 conveys the wafer 90 down the production line for subsequent processing steps, subsequent testing steps, or completion of the production flow. When the wafer 90 is determined to have not met the predetermined standard, the system 1 conveys the wafer 90 to the load port 70 for further examination, rework, or disposal.

The system 1 determines the thickness of the coating layer of the wafer 90 based on a ratio of the energy of the light beam that passes through the wafer 90, rather than based on optical measurements of reflected light from the coating layer. Therefore, the thickness determination procedure is not prone to vibration of the wafer 90 and thus is not required to include an extended waiting period for stabilization of the optical measurements. As such, the system 1 of the disclosure enhances the efficiency of coating thickness determination.

Moreover, the system 1 is capable of determining whether there is a defect in the coating layer of the wafer 90 directly based on the pixel values of the wafer image of the grayscale image 50, and does not require training an artificial intelligence to perform such determination (which could be difficult to achieve at early stages when training samples of the wafer are insufficient).

In the description above, for the purposes of explanation, numerous specific details have been set forth in order to provide a thorough understanding of the embodiment(s). It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects; such does not mean that every one of these features needs to be practiced with the presence of all the other features. In other words, in any described embodiment, when implementation of one or more features or specific details does not affect implementation of another one or more features or specific details, said one or more features may be singled out and practiced alone without said another one or more features or specific details. It should be further noted that one or more features or specific details from one embodiment may be practiced together with one or more features or specific details from another embodiment, where appropriate, in the practice of the disclosure.

## Claims

1. A system (1) for inspecting a wafer (90) having a coating layer, **characterized by**:
a main body (11) defining an inspection space (110) where the wafer (90) is to be disposed;
an optical sensor module (13) mounted on said main body (11) and configured to inspect the wafer (90) so as to obtain a sensing dataset of the wafer (90); and
a processing module (14) electrically connected to said optical sensor module (13) and configured to perform a quality determination process to determine whether a quality of the coating layer of the wafer (90) meets a predetermined standard based on the sensing dataset.

2. The system (1) as claimed in claim 1, wherein said optical sensor module (13) includes:
a backlight module (131) disposed on said main body (11) at a lower part of the inspection space (110) and configured to emit light upwardly; and
a charge-coupled device (CCD) (132) disposed on said main body (11) at an upper part of the inspection space (110) over said backlight module (131), and configured to obtain a grayscale image (50) containing the wafer (90) that is disposed in the inspection space (110) between said CCD (132) and said backlight module (131),
wherein the sensing dataset obtained by said optical sensor module (13) at least includes the grayscale image (50).

3. The system (1) as claimed in claim 2, wherein the quality determination process includes determining whether the coating layer of the wafer (90) is uniform based on the grayscale image (50).

4. The system (1) as claimed in claim 3, wherein said processing module (14) is configured to determine whether the coating layer of the wafer (90) is uniform by:
obtaining a wafer image of the wafer (90) from the grayscale image (50), the wafer image including a plurality of pixels each having a pixel value;
calculating a standard deviation of the pixel values respectively of the plurality of pixels of the wafer image;
determining whether the standard deviation of the pixel values of the plurality of pixels of the wafer image is smaller than a standard deviation threshold;
in response to determining that the standard deviation is smaller than the standard deviation threshold, determining that the coating layer of the wafer (90) is uniform and that the quality of the coating layer of the wafer (90) meets the predetermined standard; and
in response to determining that the standard deviation is not smaller than the standard deviation threshold, determining that the coating layer of the wafer (90) is not uniform and that the quality of the coating layer of the wafer (90) does not meet the predetermined standard.

5. The system (1) as claimed in any one of claims 2 to 4, wherein the quality determination process includes determining whether a defect exists in the coating layer of the wafer (90) based on the grayscale image (50).

6. The system (1) as claimed in claim 5, wherein said processing module (14) is configured to determine whether a defect exists in the coating layer of the wafer (90) by:
obtaining a wafer image of the wafer (90) from the grayscale image (50), the wafer image including a plurality of pixels each having a pixel value;
determining whether the wafer image has a connected pixel region (52), where each pixel of the connected pixel region (52) has a pixel value greater than a predetermined white value and a pixel count of the connected pixel region (52) is greater than a predetermined count value;
in response to determining that the wafer image has the connected pixel region (52), determining that there is a defect in the coating layer of the wafer (90) and that the quality of the coating layer of the wafer (90) does not meet the predetermined standard; and
in response to determining that the wafer image does not have a connected pixel region (52), determining that there is no defect in the coating layer of the wafer (90) and that the quality of the coating layer of the wafer (90) meets the predetermined standard.

7. The system (1) as claimed in claim 6, wherein the predetermined white value is 150, and the predetermined count value is 20.

8. The system (1) as claimed in any one of claims 4 to 7, wherein said processing module (14) is configured to obtain the wafer image by circling a circular portion (51) of the grayscale image (50) with a predetermined radius and a center at a predetermined position of the grayscale image (50), and using the circular portion (51) as the wafer image.

9. The system (1) as claimed in any one of claims 1 to 8, wherein:
said optical sensor module (13) includes an optical transmitter (133) and an optical receiver (134);
one of said optical transmitter (133) and said optical receiver (134) is disposed at an upper part of the inspection space (110), and another one of said optical transmitter (133) and said optical receiver (134) is disposed at a lower part of the inspection space (110);
said optical transmitter (133) is configured to emit a light beam at a predetermined power toward the wafer (90) that is disposed in the inspection space (110) between said optical transmitter (133) and said optical receiver (134);
said optical receiver (134) is configured to receive the light beam emitted by said optical transmitter (133), and to determine a received power of the light beam thus received;
said sensing dataset obtained by said optical sensor module (13) at least includes the received power; and
said processing module (14) is configured to pre-store the predetermined power and the quality determination process includes determining whether a thickness of the coating layer of the wafer (90) lies within a predetermined standard range based on the received power and the predetermined power.

10. The system (1) as claimed in claim 9, wherein:
said optical transmitter (133) is an infrared (IR) emitter configured to emit an infrared light beam, and
said optical receiver (134) is an IR receiver configured to receive the infrared light beam.

11. The system (1) as claimed in claim 9 or 10, wherein said processing module (14) is configured to further pre-store a first percentage and a second percentage corresponding respectively to an upper limit and a lower limit of the predetermined standard range, and to determine whether the thickness of the coating layer of the wafer (90) lies within the predetermined standard range by:
calculating a ratio of the received power to the predetermined power;
determining whether the ratio of the received power to the predetermined power is between the first percentage and the second percentage;
in response to determining that the ratio is not between the first percentage and the second percentage, determining that the thickness of the coating layer of the wafer (90) does not lie within the predetermined standard range and that the quality of the coating layer of the wafer (90) does not meet the predetermined standard; and
in response to determining that the ratio is between the first percentage and the second percentage, determining that the thickness of the coating layer of the wafer (90) lies within the predetermined standard range and that the quality of the coating layer of the wafer (90) meets the predetermined standard.

12. The system (1) as claimed in claim 11, wherein the first percentage is equal to 20% and the second percentage is equal to 16%.

13. The system (1) as claimed in any one of claims 9 to 12, further **characterized by** a conveying mechanism (12) that is electrically connected to said processing module (14) and that is configured to be controlled by said processing module (14) to horizontally convey the wafer (90) through the system (1),
wherein said processing module (14) is configured to control said conveying mechanism (12) to horizontally move the wafer (90) to pass between said optical transmitter (133) and said optical receiver (134), and to control said optical transmitter (133) to emit the light beam to the wafer (90) for multiple times, and said optical receiver (134) is configured to obtain a plurality of received powers of the light beam that correspond respectively to a plurality of sensing spots scattered on the coating layer of the wafer (90), and
said processing module (14) is further configured to determine whether the thickness of the coating layer of the wafer lies within the predetermined standard range by
calculating an average value of the plurality of received powers, calculating a ratio of the average value to the predetermined power,
determining whether the ratio is between the first percentage and the second percentage,
in response to determining that the ratio is not between the first percentage and the second percentage, determining that the thickness of the coating layer of the wafer (90) does not lie within the predetermined standard range and that the quality of the coating layer of the wafer (90) does not meet the predetermined standard, and
in response to determining that the ratio is between the first percentage and the second percentage, determining that the thickness of the coating layer of the wafer (90) lies within the predetermined standard range and that the quality of the coating layer of the wafer (90) meets the predetermined standard.

14. The system (1) as claimed in any one of claims 1 to 13, further **characterized by** a conveying mechanism (12) that is electrically connected to said processing module (14), that is configured to horizontally convey the wafer through the system (1) and that is adapted to be connected to a load port (70),
wherein said processing module (14) is further configured to, in response to determining that the quality of the coating layer of the wafer (90) does not meet the predetermined standard, control said conveying mechanism (12) to convey the wafer (90) to the load port (70).
